Europäisches Patentamt

European Patent Office

Office européen des brevets

(11) Publication number: **0 061 271**
**B1**

# EUROPEAN PATENT SPECIFICATION

(45) Date of publication of patent specification: **06.08.86**

(51) Int. Cl.⁴: **G 11 C 11/24**

(21) Application number: **82301274.5**

(22) Date of filing: **12.03.82**

(54) **MOS dynamic memory device.**

(30) Priority: **13.03.81 JP 36945/81**

(43) Date of publication of application:
**29.09.82 Bulletin 82/39**

(45) Publication of the grant of the patent:
**06.08.86 Bulletin 86/32**

(84) Designated Contracting States:
**DE FR GB NL**

(56) References cited:
**EP-A-0 023 847**
**US-A-4 176 289**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**1-20-5-9-301, Utsukushigaoka Midori-ku**
**Yokohama-shi Kanagawa 227 (JP)**
Inventor: **Nakano, Tomio**
**1-11-2-12-404, Shirahatadai Takatsu-ku**
**Kawasaki-shi Kanagawa 213 (JP)**
Inventor: **Ohira, Tsuyoshi**
**Fujitsu Dai 2 Eda-ryo 440-1, Eda-cho Midori-ku**
**Yokohama-shi Kanagawa 226 (JP)**

(74) Representative: **George, Sidney Arthur et al**
**GILL JENNINGS & EVERY 53-64 Chancery Lane**
**London WC2A 1HN (GB)**

## Description

This invention relates to a semiconductor memory device, and particularly to an MOS dynamic memory device having an output circuit with increased output level.

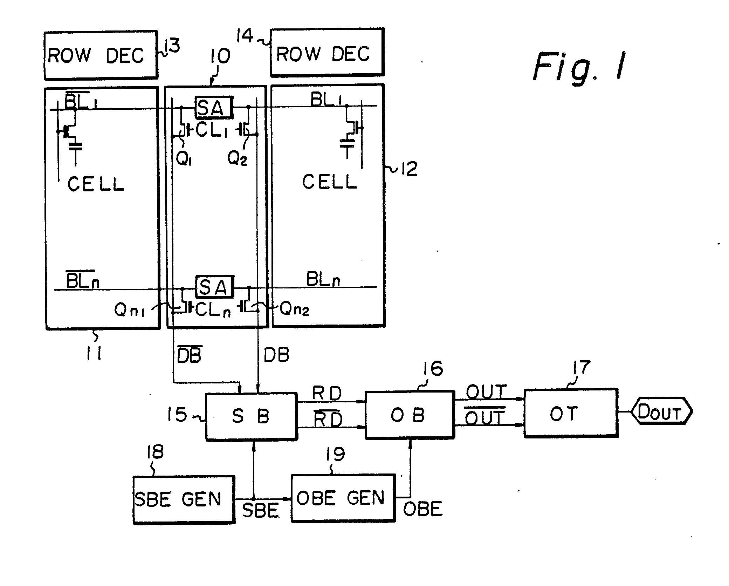

As shown in Fig. 1 of the accompanying drawings, an MOS dynamic memory device generally comprises sense amplifier circuits SA and a group of column decoders 10 arranged in the centre of a semiconductor substrate (chip), as well as a group of memory cells 11, 12 and a group of row decoders 13, 14 arranged at each side of the semiconductor substrate. In the memory device, a sense buffer circuit 15 is connected to a pair of data buses DB, $\overline{DB}$ leading from the group of column decoders 10, and a data output $D_{out}$ is obtained by a system comprising the sense buffer circuit 15, an output buffer circuit 16, and a group of output transistors 17. The column decoders 10 produce output signals $CL_1$ to $CL_n$. Gate transistors $Q_1$—$Q_{n2}$ are turned on and off by the output signals $CL_1$ to $CL_n$. Bit lines $BL_1$ to $\overline{BL_n}$ are connected to the sense amplifiers SA. An SBE (sense buffer enable) signal generator 18 and an OBE (output buffer enable) signal generator 19 provide SBE and OBE signals for actuating, respectively, the sense buffer circuit 15 and the output buffer circuit 16.

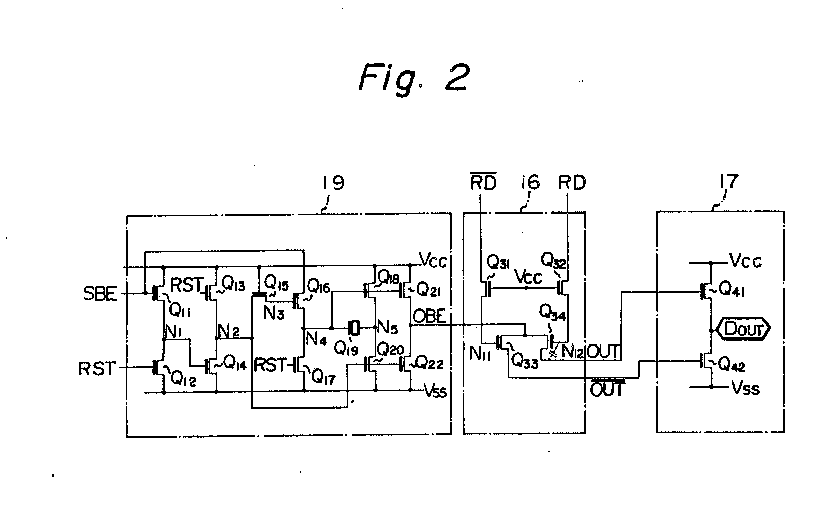

The OBE generator 19, the output buffer circuit 16, and the group of output transistors 17 of the device of Fig. 1 are illustrated in detail in Fig. 2. As shown in Fig. 2, the OBE generator 19 consists of MOS transistors $Q_{11}$ to $Q_{22}$; the output buffer circuit 16 consists of MOS transistors $Q_{31}$ to $Q_{34}$, and the group of output transistors 17 consists of MOS transistors $Q_{41}$ and $Q_{42}$. The transistors $Q_{11}$ to $Q_{22}$, $Q_{31}$ to $Q_{34}$, and $Q_{41}$ and $Q_{42}$ are connected between voltage sources $V_{CC}$ and $V_{SS}$. The transistors are interconnected at nodes N1 to N5, N11 and N12. RST indicates a reset signal.

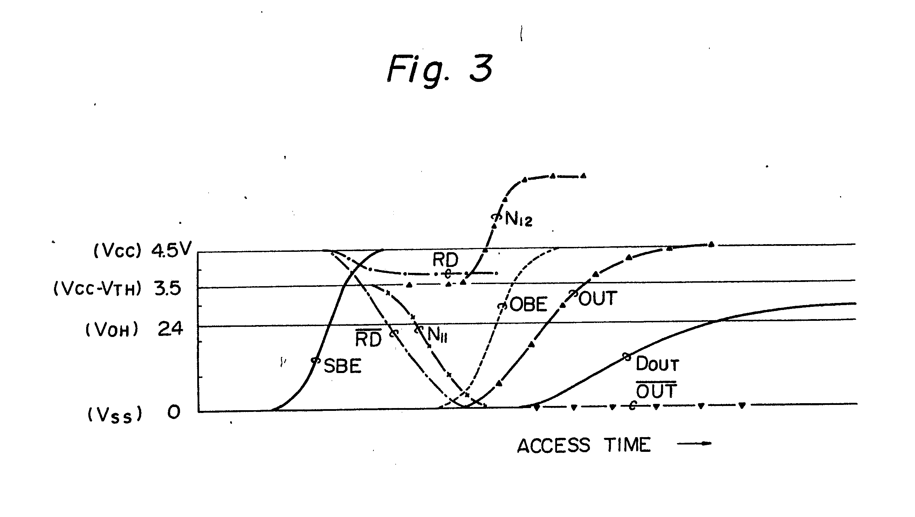

The operation of the circuit of Fig. 2 will be described with reference to Fig. 3, in which various wave forms of the voltages of signals appearing in the circuit are illustrated.

At first, when the SBE signal from the signal generator 18 rises, the sense buffer circuit 15 is actuated and starts to operate to turn one of its outputs RD and $\overline{RD}$ to the "H" level and the other output to the "L" level in accordance with the read-out data from the data buses DB and $\overline{DB}$. In the case shown in Fig. 3, it turns the output RD to the "H" level and the output $\overline{RD}$ to the "L" level. The output buffer circuit 16 receives the signals OBE, RD and $\overline{RD}$, and in the circuit 16, in response to the signal RD, the transistor $Q_{34}$ is turned ON and the transistor $Q_{33}$ is turned OFF. Therefore, one output OUT rises in accordance with the rising of the signal OBE and the other output $\overline{OUT}$ remains at the "L" level.

In the group of output transistors 17 receiving the output signals OUT and $\overline{OUT}$, the transistor $Q_{41}$ is turned ON, the transistor $Q_{42}$ is turned OFF, and, accordingly, the output signal $D_{out}$ is turned to the "H" level.

In the above-mentioned memory device, the "H" level of the output signal OBE from the signal generator is almost equal to the level of the voltage source $V_{CC}$ due to the bootstrap effect produced by an MOS capacitor $Q_{19}$. Accordingly, even though this "H" level of the output signal OBE may be transmitted directly to the output signal OUT or $\overline{OUT}$ of the output buffer circuit 16 by means of the bootstrap effect of the gate capacitance of the transistor $Q_{33}$ or $Q_{34}$, the maximum level of the signals OUT, $\overline{OUT}$ is that of the voltage source $V_{CC}$. Therefore the level of the final output signal $D_{out}$ becomes less than the voltage source $V_{CC}$, at least by the threshold level $V_{TH}$ of the transistor $Q_{41}$. Although it is necessary that the "H" level $V_{OH}$ of the final output $D_{out}$ be higher than 2.4 volts under the condition that the load current of a predetermined value is flowing, it may be difficult to fulfil the above-mentioned requirement in any case in accordance with the circuit of Fig. 2. For example, assuming that the voltage source $V_{CC}$=4.5V and the threshold level of the transistor Q41 is $V_{TH}$=1.0, the maximum level of the output $D_{out}$ is less than $(V_{CC}-V_{TH})$=3.5V, and, when the load current increases, the level of the output $D_{out}$ decreases, so that it may be less than 2.4V. In such a case, the rise time of the output $D_{out}$ is slow, as shown in Fig. 3, and, accordingly, the access time of the memory device increases.

An object of the present invention is to overcome the above-mentioned disadvantage of the prior art memory device, and to provide a semiconductor memory device in which the level of the output buffer enable signal OBE is increased so that the "H" level of the signals OUT, $\overline{OUT}$ is increased, resulting in a higher output level $V_{OH}$ and a shorter access time.

In accordance with of the present invention, there is provided a semiconductor memory device comprising an output buffer circuit to receive data signals read out from a memory cell; an output stage MOS transistor which is turned ON and OFF according to an output signal from the output buffer circuit; and an output buffer enable signal generator circuit for generating an OBE signal which is used as a voltage supply for an output stage of the output buffer circuit; characterised in that a voltage generator circuit is provided for generating a voltage $V_{BS}$ which is higher than a supply voltage $V_{CC}$ preceding the rising of the OBE signal to a higher level than the supply voltage $V_{CC}$, the voltage $V_{BS}$ being fed as a voltage supply to an output stage of the OBE signal generator circuit, whereby the OBE signal comprises a voltage waveform which rises rapidly to a level higher than the supply voltage $V_{CC}$.

An embodiment of the present invention will now be described, by way of example, with reference to the accompanying drawings, in which:

Fig. 1 is a block diagram of a prior art MOS dynamic memory device as described above,

Fig. 2 is a detailed circuit diagram of an OBE signal generator circuit, an output buffer circuit, and a group of output transistors in the device of Fig. 1,

Fig. 3 illustrates various voltage waveforms appearing in the circuit of Fig. 2,

Fig. 4 is a block diagram of a semiconductor memory device in accordance with the present invention;

Fig. 5 illustrates various voltage waveforms for explaining the operation of the device of Fig. 4,

Fig. 6 is a detailed circuit diagram of an OBE signal generator circuit and a $V_{BS}$ voltage generator circuit in the device of Fig. 4, and

Fig. 7 illustrates various voltage waveforms appearing in the circuit of Fig. 6.

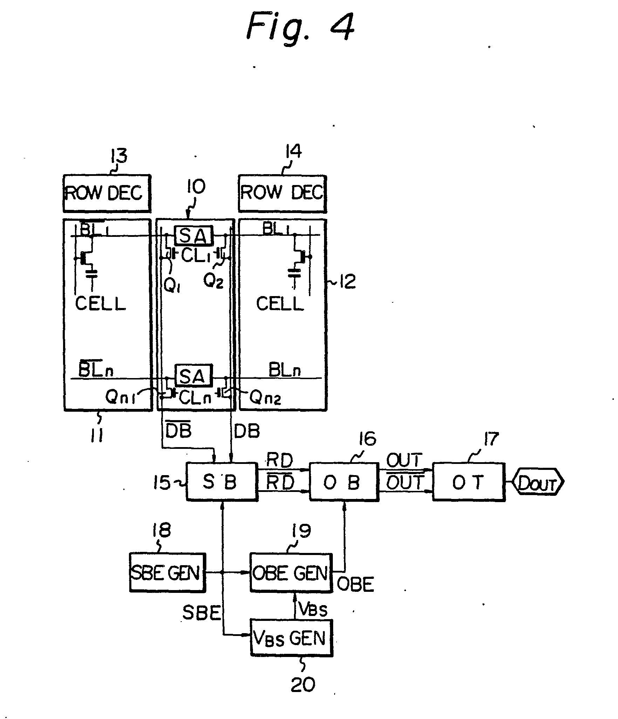

An MOS dynamic memory device according to the present invention is illustrated in Fig. 4 of the drawings. The memory device of Fig. 4 has the same construction as the device of Fig. 1 described above, except that it further comprises a $V_{BS}$ voltage generator circuit 20 for generating a voltage signal $V_{BS}$ higher than the supply voltage $V_{CC}$, the voltage signal $V_{BS}$ being used as a voltage supply to the output stage of the OBE signal generator circuit 19 instead of the voltage $V_{CC}$.

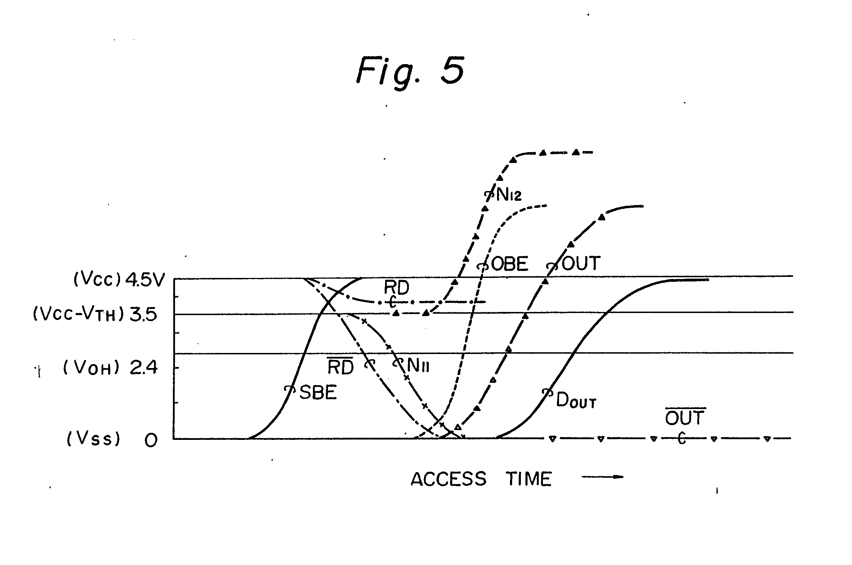

Various voltage waveforms in the device of Fig. 4 are illustrated in Fig. 5 to explain the operation of the memory device according to the present invention. As shown in Fig. 5, in the latter device the signal OBE rises rapidly to a level higher than the supply voltage $V_{CC}$. Accordingly, the output OUT of the buffer circuit 16 also rises above the supply voltage $V_{CC}$, and therefore the final output $D_{out}$ rises rapidly almost to the level of the supply voltage $V_{CC}$. Hence, the output signal $D_{out}$ becomes sufficiently higher than the required "H" output level $V_{OH}=2.4V$, and the access time of the memory device becomes shorter due to the decrease in rise time.

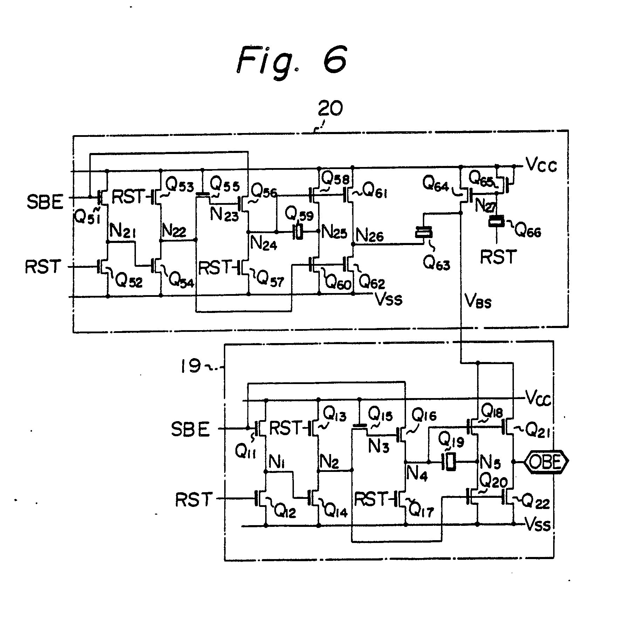

A detailed circuit diagram of the OBE signal generator circuit 19 and a $V_{BS}$ voltage generator circuit 20, by which circuits the above-mentioned operation of the memory device is realised, is illustrated in Fig. 6. The OBE signal generator circuit 19 of Fig. 6 has the same construction as that of Fig. 2, except that the output stage transistors $Q_{18}$ and $Q_{21}$ of Fig. 6 are connected to a $V_{BS}$ output of the voltage generator circuit 20 instead of to the supply voltage $V_{CC}$, which voltage $V_{BS}$ rises higher than the supply voltage $V_{CC}$. The voltage generator circuit 20 consists of MOS transistors $Q_{51}$ to $Q_{66}$ which are interconnected between the supply voltages $V_{CC}$ and $V_{SS}$ as shown in Fig. 6. The transistors are interconnected at nodes N21 to N27.

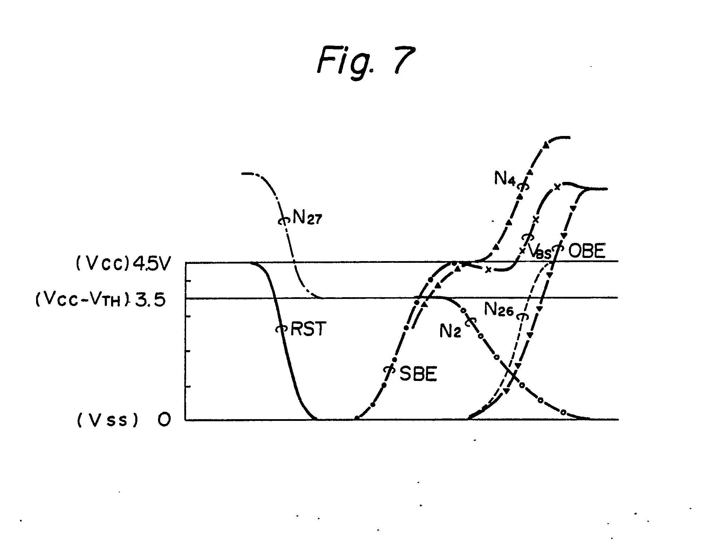

The operation of the circuit of Fig. 6 will now be described with reference to the various voltage waveforms in Fig. 7. At first, a reset signal RST, which is one of the input signals to the voltage generator circuit 20, remains at the "H" level, and the signal SBE, which is another input to the circuit 20, remains at the "L" level. Thus, the transistor $Q_{52}$ is kept ON, the transistor $Q_{51}$ is kept OFF, the node N21 is kept at the "L" level, the

transistor $Q_{54}$ is kept OFF and the transistor $Q_{53}$ is kept ON. Therefore, the nodes N22 and N23 remain at the "H" level (accordingly, the gate capacitance of the transistor $Q_{56}$ is charged up), and the transistors $Q_{60}$ and $Q_{62}$ are kept ON. In addition, the node N24 remains at the "L" level, and therefore the transistors $Q_{58}$ and $Q_{61}$ are kept OFF and the nodes N25 and N26 remain at the "L" level. Furthermore, the node N27 remains at an "HH" level, higher than the normal "H" level, due to the push-up effect produced by the MOS capacitor $Q_{66}$ and the signal RST, so that the transistor $Q_{64}$ is kept fully ON. Therefore, the MOS capacitor $Q_{63}$ is charged up to the level of the supply voltage $V_{CC}$. Thus, at this stage, the output voltage $V_{BS}$ of the voltage generator circuit 20 is kept at the $V_{CC}$ level.

In the above-mentioned condition, when the signal RST falls, the potential of the node N27 falls to a level lower than the $V_{CC}$ level by the threshold voltage $V_{TH}$ of the transistor $Q_{65}$, and the MOS capacitor $Q_{66}$ is charged up to this potential $(V_{CC}-V_{TH})$, so that any charge lost in the capacitor $Q_{66}$, while the push-up effect is being carried out, is compensated for. In addition the output voltage $V_{BS}$, which has been kept at the $V_{CC}$ level, becomes disconnected from the $V_{CC}$ supply because the transistor $Q_{64}$ is turned OFF. This falling of the signal RST is effected before the rising of the signal SBE. When the signal SBE rises after the falling of the signal RST, the transistor $Q_{51}$ is turned ON, $Q_{52}$ is kept OFF, the node N21 is switched to the "H" level, the transistor $Q_{54}$ is turned ON, the transistor $Q_{53}$ is kept OFF, the node N22 is switched to the "L" level, the transistors $Q_{55}$, $Q_{60}$, $Q_{62}$ are turned OFF, and the transistor $Q_{57}$ is kept OFF. Therefore the node N24, which receives the signal SBE through the transistor $Q_{56}$ being turned ON, is set to the "H" level, the transistors $Q_{58}$ and $Q_{61}$ are turned ON, and the nodes N25 and N26 are switched to the "H" level. Since the MOS capacitor $Q_{63}$ is charged up to the supply voltage $V_{CC}$ as described above, the output voltage $V_{BS}$ is pushed up above the supply voltage $V_{CC}$, as shown in Fig. 7, when the node N26 rises up to the level of $V_{CC}$ due to the bootstrap effect of the MOS capacitor $Q_{59}$.

In the OBE signal generator circuit 19, when the signal SBE rises the transistor $Q_{11}$ is turned ON, the transistor $Q_{12}$ is turned OFF, the node N1 is set to the "H" level, the transistor $Q_{14}$ is turned ON, and the transistor $Q_{13}$ is turned OFF, and, accordingly, the node N2 falls to the "L" level. Thus, the transistors $Q_{20}$ and $Q_{22}$ are turned OFF. At the period between the signal SBE rising and the node N3 being charged, the transistor $Q_{16}$ is kept ON and the transistor $Q_{17}$ is turned OFF. Accordingly, the node N4 rises together with the signal SBE. Hence, the transistors $Q_{18}$ and $Q_{21}$ are turned ON and are more fully turned ON due to the bootstrap effect provided by the MOS capacitor $Q_{19}$. Therefore, the levels of the node N5 and the output OBE rise rapidly above the supply voltage $V_{CC}$ following the output voltage $V_{BS}$ which is pushed up to the "HH" level, as shown in Fig. 7.

By obtaining the above-mentioned signal OBE, the output voltage OUT of the output buffer circuit 16, which has the same construction as that of Fig. 2, attains an "HH" level almost equal to that of the signal OBE because the transistor $Q_{34}$ is kept ON by its gate capacity; then the output transistor $Q_{41}$ is fully turned ON and the output $D_{out}$ is turned to an "H" level almost equal to the $V_{CC}$ level.

As a way of raising the output voltage to a level almost equal to the supply voltage $V_{CC}$, a bootstrap circuit similar to the circuit using the capacitors $Q_{19}$ and $Q_{59}$ shown in Fig. 2 or Fig. 6 may be utilised. However, such an arrangement is not suitable for speeding up the rise of the output signal $D_{out}$. That is, in such an arrangement, the MOS capacitors $Q_{19}$ and $Q_{59}$ are first charged up at the arrival of the signal SBE. Then the levels of the nodes N5 and N25 are raised so that the bootstrap effect is put into action, and the final output voltage rises to the level of the supply voltage $V_{CC}$. Therefore, the time required for the output voltage to reach the supply voltage $V_{CC}$ is relatively long. Hence, since the access time of the memory device is long, the above-mentioned arrangement does not fulfil the object of the present invention.

In the circuit of Fig. 6, according to the present invention, the capacitor $Q_{63}$ is charged up preceding the rising of the signal SBE, the transistor $Q_{64}$ in the charging circuit for the capacitor $Q_{63}$ is turned OFF so that the output terminal $V_{BS}$ is set in a floating state. Then the output voltage $V_{BS}$ is pushed up via the capacitor $Q_{63}$ by the rising of the node N26 in response to the rising of the signal SBE, and the output voltage $V_{BS}$ is increased. Thus, the circuit of Fig. 6 has an advantage in that there is no delay in operation. Since the capacitor $Q_{63}$ is used as a voltage supply for the signal SBE and is necessary to charge up parasitic capacitance accompanying the signal line SBE, the capacitance of the capacitor $Q_{63}$ should be relatively large. Because the capacitor $Q_{63}$ has been charged up through the transistor $Q_{64}$ preceding the rising of the signal SBE, the large capacitance of the capacitor $Q_{63}$ does not cause a delay in operation.

As described above, according to the present invention, the "H" level of the data output $D_{out}$ can be made equal to the level of the supply voltage $V_{CC}$, and the access time of the memory device can be decreased by speeding up the rising transition of the data output $D_{out}$.

## Claims

1. A semiconductor memory device comprising an output buffer circuit (16) to receive data signals (RD, $\overline{RD}$) read out from a memory cell (11, 12); an output stage MOS transistor (17) which is turned ON and OFF according to an output signal from the output buffer circuit; and an output buffer enable (OBE) signal generator circuit (19) for generating an OBE signal which is used as a voltage supply for an output stage of the output buffer circuit; characterised in that a voltage generator circuit (20) is provided for generating a voltage $V_{BS}$ which is higher than a supply voltage $V_{CC}$ preceding the rising of the OBE signal to a higher level than the supply voltage $V_{CC}$, the voltage $V_{BS}$ being fed as a voltage supply to an output stage of the OBE signal generator circuit, whereby the OBE signal comprises a voltage waveform which rises rapidly to a level higher than the supply voltage $V_{CC}$.

2. A semiconductor memory device as claimed in claim 1, characterised in that in the $V_{BS}$ voltage generator circuit (20) the voltage $V_{BS}$ higher than the supply voltage $V_{CC}$ is generated by means of a push-up capacitor (Q63).

3. A semiconductor memory device as claimed in claim 2, characterised in that the OBE signal generator circuit (19) is driven in response to a sense buffer enable (SBE) signal; and in that the push-up capacitor (Q63) in the $V_{BS}$ voltage generator circuit is driven by a driver circuit (Q51—Q65) in response to the SBE signal.

4. A semiconductor memory device as claimed in any preceding claim, characterised in that the output buffer circuit (16) delivers complementary output signals (OUT, $\overline{OUT}$) each having HIGH and LOW potential states; in that the output buffer stage (17) comprises a first MOS transistor (Q41) the gate of which receives one (OUT) of the complementary output signals and the drain of which is connected to the supply voltage $V_{CC}$, and a second MOS transistor (Q42) the gate of which receives the other ($\overline{OUT}$) of the complementary output signals and the source of which is connected to a lower supply voltage ($V_{SS}$), the junction between the first and second MOS transistors (Q41, Q42) being connected to an output terminal ($D_{out}$) of the semiconductor memory device; and in that the HIGH potential of said one (OUT) of the complementary output signals is higher than the supply voltage $V_{CC}$ and the HIGH potential of the output terminal ($D_{out}$) of the semiconductor memory device is the potential of the supply voltage $V_{CC}$.

**Patentansprüche**

1. Halbleiterspeichervorrichtung mit einer Ausgangspufferschaltung (16) zum Empfang von Datensignalen (RD, $\overline{RD}$), die von einer Speicherzelle (11, 12) ausgelesen werden; einem Ausgangsstufen - MOS - Transistor (17), der, in Übereinstimmung mit einem Ausgangssignal von der Ausgangspufferschaltung, EIN- und AUSgeschaltet wird; und einem Ausgangspuffer - Freigabe - OBE - Signal - Generator (19) zur Erzeugung eines OBE-Signals, welches als eine Spannungsversorgung für eine Ausgangsstufe der genannten Ausgangspufferschaltung verwendet wird; dadurch gekennzeichnet, daß eine Spannungsgeneratorschaltung (20) vorgesehen ist, für die Erzeugung einer Spannung $V_{BS}$, die höher als die Versorgungsspannung $V_{CC}$ ist, die dem Anstieg des OBE-Signals zu einem höheren Pegel als der Versorgungsspannung $V_{CC}$ vor-

hergeht, wobei die Spannung $V_{BS}$ als eine Versorgungsspannung zu einer Ausgangsstufe der Generatorschaltung des OBE-Signals eingespeist wird, wodurch das OBE-Signal eine Spannungswellenform hat, welche schnell auf einen Pegel oberhalb der Versorgungsspannung $V_{CC}$ ansteigt.

2. Halbleiterspeichervorrichtung nach Anspruch 1, dadurch gekennzeichnet, daß in der Generatorschaltung (20) der $V_{BS}$-Spannung die Spannung $V_{BS}$ höher als die Versorgungsspannung $V_{CC}$ ist, die mittels eines Push-up-Kondensators (Q63) erzeugt wird.

3. Halbleiterspeichervorrichtung nach Anspruch 2, dadurch gekennzeichnet, daß die Generatorschaltung (19) für das OBE-Signal auf eine Lesepufferfreigabe - (SBE - )Signal ansprechend getrieben wird; und daß der Push - up - Kondensator (Q63) in der Generatorschaltung der $V_{BS}$-Spannung durch einen Treiberkreis (Q51—Q65) auf das SBE-Signal ansprechend getrieben wird.

4. Halbleiterspeichervorrichtung nach einem der vorhergehenden Ansprüche, dadurch gekennzeichnet, daß die Ausgangspufferschaltung (16) komplementäre Ausgangssignale (OUT, $\overline{OUT}$) liefert, die jeweils HOHE und NIEDRIGE Potentialzustände haben; daß die Ausgangspufferstufe (17) einen ersten MOS-Transistor (Q41) umfaßt, dessen Gate ein (OUT) der komplementären Ausgangssignale empfängt und dessen Drain mit der Versorgungsspannung $V_{CC}$ verbunden ist, und einen zweiten MOS-Transistor (Q42), dessen Gate das andere ($\overline{OUT}$) der komplementären Ausgangssignale umfaßt und dessen Source mit einer niedrigen Versorgungsspannung ($V_{SS}$) verbunden ist, wobei die Verbindung zwischen den ersten und zweiten MOS-Transistoren (Q41, Q42) mit einem Ausgangsanschluß ($D_{out}$) der Halbleiterspeichervorrichtung verbunden ist; und daß das HOHE Potential des genannten einen (OUT) der komplementären Ausgangssignale höher als die Versorgungsspannung ($V_{CC}$) und das HOHE Potential des Ausgangsanschlusses ($D_{out}$) der Halbleiterspeichervorrichtung das Potential der Versorgungsspannung $V_{CC}$ ist.

## Revendications

1. Dispositif de mémoire à semiconducteur comprenant un circuit tampon de sortie (16) servant à recevoir des signaux de données (RD, $\overline{RD}$) lus dans une cellule de mémoire (11, 12); un transistor MOS d'étage de sortie (17) qui est rendu conducteur et non conducteur en fonction du signal de sortie venant du circuit tampon de sortie; et un circuit (19) générateur de signaux de validation de tampon de sortie (OBE) servant à produire un signal OBE qui est utilisé comme alimentation en tension pour un étage de sortie du circuit tampon de sortie; caractérisé en ce qu'un circuit (20) générateur de tension est destiné à produire une tension $V_{BS}$ qui est plus élevée qu'une tension d'alimentation $V_{CC}$ antérieurement à la montée du signal OBE jusqu'à un niveau supérieur à la tension d'alimentation $V_{CC}$, la tension $V_{BS}$ étant fournie comme alimentation en tension à un étage de sortie du circuit générateur de signaux OBE, si bien que le signal OBE comprend une forme d'onde de tension qui monte rapidement jusqu'à un niveau supérieur à celui de la tension d'alimentation $V_{CC}$.

2. Dispositif de mémoire à semiconducteur selon la revendication 1, caractérisé en ce que, dans le circuit (20) générateur de tension $V_{BS}$, la tension $V_{BS}$ plus élevée que la tension d'alimentation $V_{CC}$ est produite par l'intermédiaire d'un condensateur de tirage vers le haut ($Q_{63}$).

3. Dispositif de mémoire à semiconducteur selon la revendication 2, caractérisé en ce que le circuit (19) générateur de signaux OBE est excité sous commande d'un signal de validation de tampon d'analyse-lecture (SBE) et en ce que le condensateur de tirage vers le haut ($Q_{63}$) du circuit générateur de tension $V_{BS}$ est excité par un circuit d'excitation ($Q_{51}$ à $Q_{65}$) en réponse au signal SBE.

4. Dispositif de mémoire à semiconducteur selon l'une quelconque des revendications précédentes, caractérisé en ce que le circuit tampon de sortie (16) délivre des signaux de sortie complémentaires (OUT, $\overline{OUT}$) ayant chacun des états de potentiel haut (H) et bas (B); en ce que l'étage tampon de sortie (17) comprend un premier transistor MOS ($Q_{41}$) dont la grille reçoit l'un (OUT) des signaux de sortie complémentaires et dont le drain est connecté à la tension d'alimentation $V_{CC}$, et un deuxième transistor MOS ($Q_{42}$) dont la grille reçoit l'autre ($\overline{OUT}$) des signaux de sortie complémentaires et dont la source est connectée à une tension d'alimentation plus basse ($V_{SS}$), la jonction entre les premier et deuxième transistors MOS ($Q_{41}$, $Q_{42}$) étant connectée à une borne de sortie ($D_{out}$) du dispositif de mémoire à semiconducteur; et en ce que le potentiel haut (H) dudit premier mentionné (OUT) des signaux de sortie complémentaires est plus élevée que la tension d'alimentation $V_{CC}$ et que le potentiel haut (H) de la borne de sortie ($D_{out}$) du dispositif de mémoire à semiconducteur est le potentiel de la tension d'alimentation $V_{CC}$.

Fig. 1

Fig. 2

Fig. 3

N_{12}

RD

OBE

OUT

$\overline{RD}$

N_{11}

SBE

D_{OUT}

$\overline{OUT}$

ACCESS TIME

(Vcc) 4.5V

(Vcc-V_{TH}) 3.5

(V_{OH}) 24

(Vss) 0

# Fig. 4

Fig. 5

0 061 271

# Fig. 6

# Fig. 7